# EUROPÄISCHE PATENTANMELDUNG

(11) **EP 3 783 375 A1**
(43) Veröffentlichungstag der Anmeldung: **24.02.2021**
(21) Anmeldenummer: 19192329.1
(22) Anmeldetag: 19.08.2019
(51) Int. Cl.: G01R 31/28, G01R 1/04

(54) **HEISS-E-TEST FÜR UNBESTÜCKTE LEITERPLATTEN**

(71) Anmelder: Dyconex AG, 8303 Bassersdorf (CH)
(72) Erfinder: Luchsinger, Daniel, 8303 Bassersdorf (CH); Messerli, Stephan, 8581 Schocherswill (CH); Johannsen, Sven, 8309 Nürensdorf (CH); Klein, Hans-Peter, 66129 Saarbrücken (DE)
(74) Vertreter: Galander, Marcus

(57) **Zusammenfassung**

Die vorliegende Erfindung betrifft ein Testverfahren für eine unbestückte Leiterplatte umfassen die Schritte: Aussetzen der unbestückten Leiterplatte unter Temperaturen eines Reflow-Lötverfahrens in einem ersten Schritt, und Testen der elektrischen Verbindungen der unbestückten Leiterplatte. Die vorliegende Erfindung betrifft weiterhin eine Testvorrichtung und ein Herstellungsverfahren für bestückte Leiterplatten.

## Beschreibung

Die vorliegende Erfindung betrifft ein Testverfahren und eine Testvorrichtung für unbestückte Leiterplatten sowie ein Herstellungsverfahren für unbestückte Leiterplatten.

Leiterplatten für elektronische Geräte werden typischerweise im unbestückten Zustand auf funktionale und strukturelle Integrität getestet. Diese Tests können beispielsweise optische Prüfung usw. umfassen. Ein wesentlicher Test ist jedoch das Finden von elektrisch unterbrochenen oder kurzgeschlossenen Verbindungen, beispielsweise in Vias oder Leiterbahnen der Leiterplatte. Diese werden üblicherweise bei Raumtemperatur durchgeführt.

Problematisch ist jedoch, dass elektrisch unsichere Verbindungen erst nachträglich auftreten können, beispielsweise nach dem Bestücken oder Verdrahten von elektronischen Bauteilen auf der Leiterplatte.

Es ist daher eine Aufgabe der vorliegenden Erfindung, Verfahren und Mittel zur Verfügung zu stellen, mit welchem zuverlässig elektrische unsichere Verbindung gefunden werden können.

Die Aufgabe wird durch ein Testverfahren mit den Merkmalen des Anspruchs 1 und einer Testvorrichtung mit den Merkmalen des Anspruchs 8 gelöst. Geeignete Ausgestaltungen sind in den entsprechenden abhängigen Ansprüchen und in der folgenden Beschreibung angegeben.

Gemäß Anspruch 1 wird ein Testverfahren für unbestückte Leiterplatten zur Verfügung gestellt. Das Testverfahren umfasst die Schritte:
a) Aussetzen der unbestückten Leiterplatte unter Temperaturen eines Reflow-Lötverfahrens, und
b) Testen der elektrischen Verbindungen der unbestückten Leiterplatte.

Der Begriff "Reflow-Lötverfahren" wird im Sinne der vorliegenden Erfindung im dem Fachmann verständlichen und gebräuchlichen Sinn verwendet. Er bezeichnet insbesondere ein in der Elektrotechnik gängiges Weichlötverfahren zum Löten von SMD (*surface mounted device*)-Bauteilen, wobei ein Weichlot, insbesondere eine Weichlotpaste, auf eine unbestückte Leiterplatte aufgetragen wird, die Leiterplatte dann mit einem oder mehreren elektronischen Bauteilen bestückt wird, und die so bestückte Leiterplatte dann erhitzt wird.

Gemäß einer Ausführungsform des erfindungsgemäßen Verfahrens ist vorgesehen, dass Schritt a) bei einer Temperatur im Bereich von 150°C bis 250°C durchgeführt wird, insbesondere ca. 210°.

Gemäß einer weiteren Ausführungsform des erfindungsgemäßen Verfahrens ist vorgesehen, dass Schritt b) bei einer Temperatur im Bereich von 100°C bis 120°C durchgeführt wird, insbesondere bei ca. 110°C.

Gemäß einer weiteren Ausführungsform des erfindungsgemäßen Verfahrens ist vorgesehen, dass Schritt a) mittels einer ersten Heizplatte und einer zweiten Heizplatte durchgeführt wird, wobei die unbestückte Leiterplatte zwischen der ersten Heizplatte und der zweiten Heizplatte angeordnet ist.

Gemäß einer weiteren Ausführungsform des erfindungsgemäßen Verfahrens ist vorgesehen, dass die erste Heizplatte, die unbestückte Leiterplatte und die zweite Heizplatte durch eine erste Rahmenplatte und eine zweite Rahmenplatte umfasst werden.

Insbesondere ist vorgesehen, dass die erste Heizplatte und die zweite Heizplatte oder die erste Rahmenplatte und die zweite Rahmenplatte durch ein magnetisches Element zusammengehalten werden. Zusätzlich oder alternativ dazu können auch die erste Heizplatte und die erste Rahmenplatte und/oder die zweite Heizplatte und die zweite Rahmenplatte miteinander laminiert sein.

Gemäß einer weiteren Ausführungsform des erfindungsgemäßen Verfahrens ist vorgesehen, dass die erste Heizplatte und/oder die zweite Heizplatte einen Heizleiter umfassen. Vorzugsweise hat der Heizleiter eine mäandrische Form.

Gemäß einer weiteren Ausführungsform des erfindungsgemäßen Verfahrens ist vorgesehen, dass die erste Heizplatte und/oder die zweite Heizplatte aus einem Kunststoff besteht oder einen solchen umfasst, beispielsweise einem glasfaserverstärkten Kunststoff wie etwa Epoxid. Vorzugsweise ist die erste Heizplatte und/oder die zweite Heizplatte mehrlagig ausgebildet.

Gemäß einer weiteren Ausführungsform des erfindungsgemäßen Verfahrens ist vorgesehen, dass die erste Rahmenplatte und/oder die zweite Rahmenplatte aus Metall besteht oder umfasst, wie etwa Stahl oder Aluminium.

Gemäß einer weiteren Ausführungsform des erfindungsgemäßen Verfahrens ist vorgesehen, dass die erste Heizplatte und/oder die zweite Heizplatte eine Beschichtung aus Kupfer aufweist, welche vorzugsweise weiterhin eine Goldbeschichtung aufweisen kann. Vorteilhafterweise kann dadurch verhindert werden, dass die Struktur der Heizplatte auf die zu testende unbestückte Leiterplatte übertragen wird. Gleichzeitig wirkt die Kupferschicht vorteilhafterweise als Wärmeverteiler (Diffusor).

Gemäß einer weiteren Ausführungsform des erfindungsgemäßen Verfahrens ist vorgesehen, dass die erste Rahmenplatte und/ die zweite Rahmenplatte aus einem kupferfreien Leiterplattenmaterial gefertigt ist.

Gemäß einer weiteren Ausführungsform des erfindungsgemäßen Verfahrens ist vorgesehen, dass die erste Heizplatte und/oder die zweite Heizplatte und/oder die erste Rahmenplatte und/oder die zweite Rahmenplatte eine Vielzahl von Öffnungen aufweist.

Vorteilhafterweise ist dabei die unbestückte Leiterplatte so zwischen den Heizplatten oder den Heizplatten und den Rahmenplatten angeordnet, dass Vias und/oder Leiterbahnen der Leiterplatten von außen durch die Öffnungen erreichbar sind.

Gemäß einer weiteren Ausführungsform des erfindungsgemäßen Verfahrens ist vorgesehen, dass das Testen der elektrischen Verbindungen einen Durchgangstest und ein Isolationstest umfasst.

Ein solcher Durchgangstest umfasst insbesondere eine Prüfung der elektrischen Verbindungen zwischen Testpunkten in einem Netzwerk, wobei sichergestellt wird, dass jeder Testpunkt mit jedem anderem Testpunkt in elektrischer Verbindung steht. Die elektrischen Verbindungen zwischen allen Testpunkten können direkt gemessen werden, beispielsweise über den Widerstand, oder indirekt über die Bestimmung der elektrischen Eigenschaften (Kapazität, Widerstand usw.) der zu prüfenden unbestückten Leiterplatte und Vergleichen mit Referenzwerten.

Ein Isolationstest umfasst insbesondere eine Prüfung der elektrischen Isolierung zwischen Testpunkten eines Netzwerkes. Die Isolation kann direkt über den Widerstand gemessen werden oder indirekt über die Bestimmung der elektrischen Eigenschaften (Kapazität, Widerstand usw.) der zu prüfenden unbestückten Leiterplatte und Vergleichen mit Referenzwerten.

Gemäß Anspruch 8 wird eine Testvorrichtung für einen Funktionstest einer unbestückten Leiterplatte zur Verfügung gestellt. Die Testvorrichtung umfasst:
- eine erste Heizplatte und eine zweite Heizplatte, wobei die erste Heizplatte und die zweite Heizplatte zur Aufnahme einer unbestückten Leiterplatte ausgebildet sind, und
- eine erste Rahmenplatte und eine zweite Rahmenplatte, wobei die erste Rahmenplatte und die zweite Rahmenplatte zur Aufnahme der ersten Heizplatte und der zweiten Heizplatte ausgebildet sind.

Insbesondere ist die erfindungsgemäße Testvorrichtung zur Durchführung des erfindungsgemäßen Testverfahrens ausgebildet.

Weiterhin kann insbesondere die erfindungsgemäße Testvorrichtung in oder an einer Vorrichtung zum Durchgangstest und/oder Isolationstest angeordnet werden.

Eine solche Vorrichtung zum Durchgangstest und/oder Isolationstest umfasst insbesondere Aufnahmeeinrichtungen zur Aufnahme der zu prüfenden unbestückten Leiterplatte, sowie eine oder mehrere Kontaktstifte oder Kontaktnadeln zum elektrischen Kontaktieren von elektrischen Kontakten.

Die Vorrichtung kann weiterhin zur automatischen Prüfung ausgebildet sein. Ein nicht beschränkendes Beispiel für eine solche Vorrichtung ist ein automatischer Tester der Firma MicroCraft, Japan, wie etwa das Modell E4H6151L.

Gemäß einer Ausführungsform der erfindungsgemäßen Testvorrichtung ist vorgesehen, dass die erste Heizplatte und/oder die zweite Heizplatte einen Heizleiter umfasst. Vorzugsweise weist der Heizleiter eine mäandrische Form auf.

Gemäß einer weiteren Ausführungsform der erfindungsgemäßen Testvorrichtung ist vorgesehen, dass die erste Heizplatte und/oder die zweite Heizplatte aus einem Kunststoff besteht oder einen solchen umfasst, beispielsweise einem glasfaserverstärkten Kunststoff wie etwa Epoxid.

Gemäß einer weiteren Ausführungsform der erfindungsgemäßen Testvorrichtung ist vorgesehen, dass die erste Heizplatte und/oder die zweite Heizplatte eine Beschichtung aus Kupfer aufweisen, wobei insbesondere die Kupferbeschichtung eine Goldbeschichtung aufweisen kann.

Gemäß einer weiteren Ausführungsform der erfindungsgemäßen Testvorrichtung ist vorgesehen, dass die erste Heizplatte und/oder die zweite Heizplatte ein Thermoelement aufweisen, wobei das Thermoelement dazu ausgebildet ist, die Temperatur in der Heizplatte zu bestimmen.

Gemäß einer weiteren Ausführungsform der erfindungsgemäßen Testvorrichtung ist vorgesehen, dass die erste Heizplatte und/oder die zweite Heizplatte einen oder mehrere Ausrichtpunkte für die unbestückte Leiterplatte aufweisen.

Gemäß einer weiteren Ausführungsform der erfindungsgemäßen Testvorrichtung ist vorgesehen, dass die erste Heizplatte und/oder die zweite Heizplatte mehrlagig ausgebildet ist.

Gemäß einer weiteren Ausführungsform der erfindungsgemäßen Testvorrichtung ist vorgesehen, dass die erste Rahmenplatte und/ die zweite Rahmenplatte aus einem kupferfreien Leiterplattenmaterial gefertigt ist.

Gemäß einer weiteren Ausführungsform der erfindungsgemäßen Testvorrichtung ist vorgesehen, dass die erste Heizplatte und/oder die zweite Heizplatte und/oder die erste Rahmenplatte und/oder die zweite Rahmenplatte eine Vielzahl von Öffnungen aufweist.

Gemäß einer weiteren Ausführungsform umfasst die erfindungsgemäße Testvorrichtung weiterhin mindestens ein magnetisches Element, welches dazu ausgebildet ist, die erste Heizplatte und die zweite Heizplatte oder die erste Rahmenplatte und die zweiten Rahmenplatte zusammen zu halten. Vorzugsweise ist das magnetische Element wärme- bzw. hitzeresistent, beispielsweise resistent gegenüber Temperaturen im Bereich von 150°C bis 250°C.

Gemäß einer Ausführungsform der erfindungsgemäßen Testvorrichtung ist vorgesehen, dass die erste Heizplatte und die erste Rahmenplatte und/oder die zweite Heizplatte und die zweite Rahmenplatte miteinander laminiert sind.

Gemäß Anspruch 15 wird ein Herstellungsverfahren für eine bestückte Leiterplatte zur Verfügung gestellt. Das Verfahren umfasst die Schritte:
- Bereitstellen einer Vielzahl von unbestückten Leiterplatten,
- Testen der Vielzahl von unbestückten Leiterplatten mit dem erfindungsgemäßen Testverfahren,
- Auswählen einer unbestückten Leiterplatte mit intakten elektrischen Verbindungen aus der Vielzahl der getesteten unbestückten Leiterplatten,
- Bestücken der ausgewählten unbestückten Leiterplatte mit intakten elektrischen Verbindungen mit einer oder mehrerer elektronischer Komponenten, und
- Durchführen eines Reflow-Schrittes mit der bestückten Leiterplatte.

Gemäß einer Ausführungsform des erfindungsgemäßen Herstellungsverfahrens ist vorgesehen, dass der Reflow-Schritte bei einer Temperatur im Bereich von 150°C bis 250 C durchgeführt wird, vorzugsweise bei etwa 210°C.

Weitere Merkmale und Vorteile der Erfindung werden nachfolgend anhand der Figurenbeschreibung von Ausführungsbeispielen erläutert. Es zeigen:
- Fig. 1: schematisch eine Ausführungsform der erfindungsgemäßen Testvorrichtung;
- Fig. 2: detailliert die Einzelkomponenten der in Figur 1 dargestellten Ausführungsform;
- Fig. 3: Detailansichten einer Einzelkomponente (Heizplatte) der in Figur 1 dargestellten Ausführungsform;
- Fig. 4: eine schematische Darstellung einer Einzelkomponente (mehrlagige Heizplatte).

Eine normale Prüfung eine unbestückten Leiterplatte besteht üblicherweise aus dem sogenannten Durchgangstest (*continuity test*) und dem Isolationstest (*insulation test*). Zum dem Finden von Via, bei denen mit erhöhter Temperatur, beispielsweise Löten, die Bodenanbindung reißen, wird der nachfolgend beschrieben, erfindungsgemäße Test vorgeschlagen.

Bei dem erfindungsgemäßen Test wird eine vollflächige Heizplatte (Bulk) verwendet, um mit einem horizontalen elektrischen Nadeltester für unbestückte Leiterplatten 1, die Integrität der Leiterbahnen und Via zu überprüfen. Die vollflächige Heizplatte limitiert allerdings die Prüfung einseitig. Um größtmögliche Abdeckung der Netze der unbestückten Leiterplatte zu erreichen, wird in zwei Durchgängen jeweils von einer Seite geprüft, einmal von der Oberseite und einmal von der Unterseite. Die zweimal einseitige Prüfung hat den Nachteil, dass Netze, die von der Ober- zur Unterseite verbunden sind, nicht geprüft werden können.

In einer Weiterentwicklung des erfindungsgemäßen Gedankens wird daher das nachfolgend beschriebene Prinzip vorgeschlagen. Beim neuen Prinzip wird der zusätzliche elektrische Durchgangstest am Produkt bei erhöhter Temperatur durchgeführt von der Ober- und Unterseite gleichzeitig durchgeführt wie bei einem ganz normalen elektrischen Test.

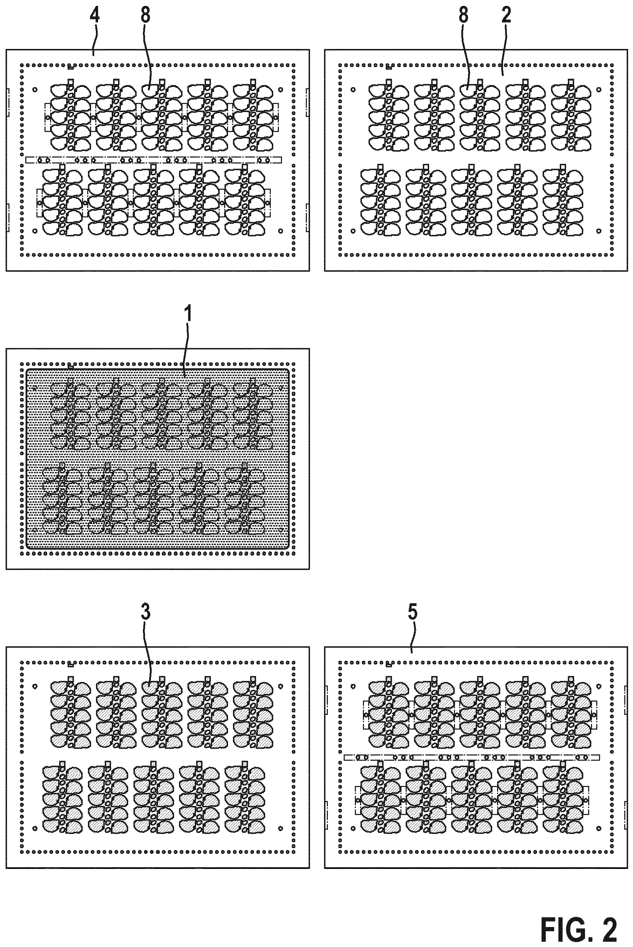

Die unbestückte Leiterplatte 1 wird dabei zwischen zwei Heizplatten 2,3 gepackt (Sandwich Prinzip), diese geheizt und die beiden elektrischen Tests - wie anfangs erwähnt - durchgeführt. Damit die elektrischen Tests besonders effizient durchgeführt werden können, ist es von Vorteil, die zweiseitig gespiegelt aufgebauten Heizplatten jedem Produkt anpassen (wie beispielweise in Figur 2 dargestellt).

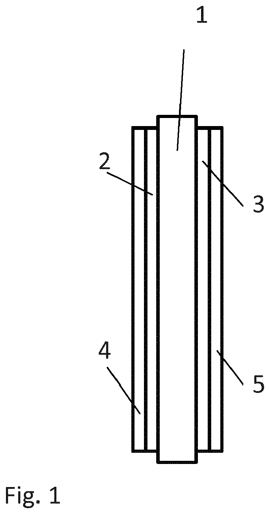

Die oben beschriebene Sandwichstruktur ist wie in Figur 1 dargestellt aufgebaut und umfasst zwei Heizplatten 2,3, welche die zu testende Leiterplatte 1 umfassen. Die Heizplatten 2, 3 wiederum sind von zwei Rahmenplatten 4,5 umgeben, welche der Sandwichstruktur Stabilität verleihen. Die Sandwichstruktur wird dabei vorzugsweise mit hochtemperatur-resistenten Magneten zusammengehalten.

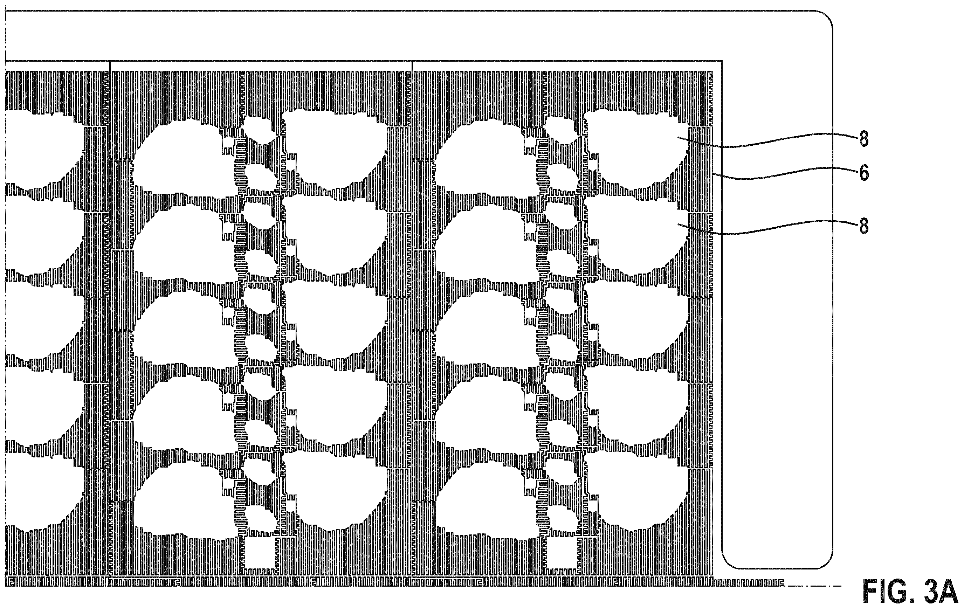

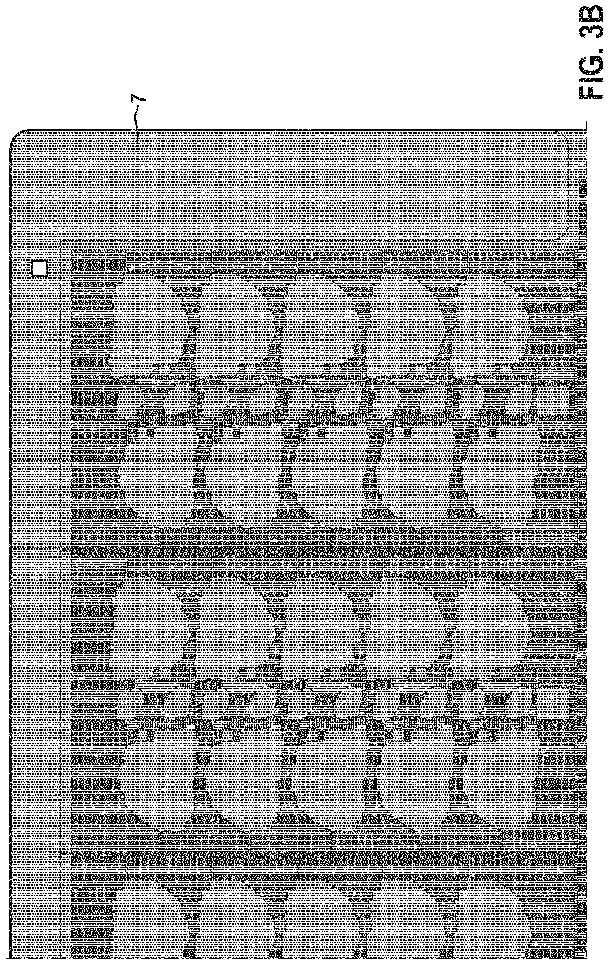

Die eigentliche Heizplatte 2,3 ist vorzugsweise eine mehrlagige Leiterplatte. Das Herzstück dieser Platten 2,3 sind die Heizleiter 6, dessen Mäander möglichst nahe um die zu prüfende aktive Leiterplattenfläche 1 angeordnet werden, damit die Wärme möglichst nur kurz migrieren muss (Figur 3a). Um zu verhindern, dass die Struktur der Heizleiter 6 auf die zu testende Leiterplatte übertragen wird, wird über den Heizleitern eine vollflächige Kupferschicht 7 angebracht, die als Wärmeverteiler (Diffusor) wirkt (Figur 3b, grün). Die Heizleistung wird seitlich über eine normale Stromzuführung erbracht. Vorteilhafterweise verfügt der elektrische Tester über einen Personenschutz verfügt, der die Stromzufuhr unterbricht, sobald dessen Tore geöffnet würden. Zum Beispiel kann ein automatischer Tester der Firma MicroCraft, Japan, verwendet werden, wie etwa das Modell E4H6151L.

In einer Weiterentwicklung des erfindungsgemäßen Gedankens werden weiterhin folgenden Verbesserungen an den erfindungsgemäßen Heizplatten 2,3 vorgeschlagen:
- Die stabilitätsgebenden äußeren Leiterplatten werden mit den Heizplatten zusammen laminiert. Damit zur noch zwei Teile zusammen gebracht werden müssen.
- In einer weiteren Lage wird ein Thermoelement eingebaut, um die Temperatur zu messen und um diese an die Maschine zurückgeben zu können.
- Auf einer weiteren, äußersten, strukturierten und vergoldeten Lage werden die Ausrichtpunkte für das zu prüfende Produkt angebracht.

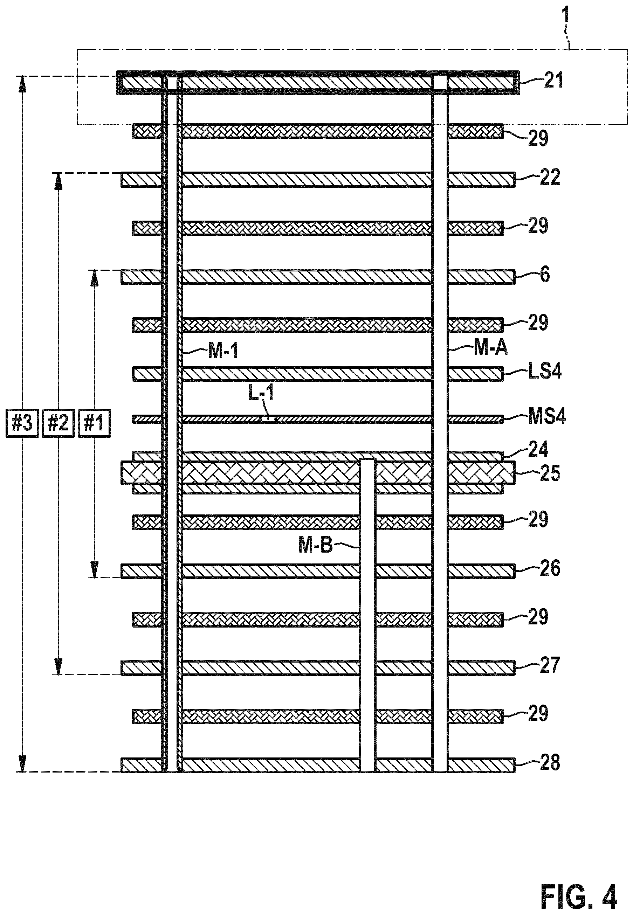

Eine bevorzugte Heizplatte ist schematisch in Figur 4 dargestellt und umfasst folgenden Lagen: eine äußere Lage mit Ausrichtpunkten (Kupfer, vergoldet) 21, eine vollflächige Kupferlage (Diffusor) 22, ein Heizmäander (Kupfer) 6, eine Lage Schutzlack für den Thermocouple LS4, wobei zwischen den vorgenannten Lagen jeweils eine Lage 29 aus einem epoxid-basierten Isolationsmaterial angeordnet ist, sowie eine Thermocouple - Lage (Constantan) MS4, eine Lage mit Tiefenfräsleiter (Kupfer) 24, eine mehrlagige Gitterstruktur (Kupfer, zur Symmetrieerhaltung und besserer Haftung) 25 bis 27, zwischen den jeweils eine Lage 29 aus einem epoxid-basierten Isolationsmaterial angeordnet ist, ferner eine Kontaktierungslage zur Maschine (Kupfer, vergoldet) 28. Die mehrlagige Heizplatte weist weiterhin eine durchgehende Konturfräsung M-B, welche in Abhängigkeit von der zu prüfenden unbestückten Leiterplatte 1 angeordnet ist, sowie eine durchgängige Durchkontaktierung M-1 auf. Weiterhin weist die mehrlagige Heizplatte eine Tiefenfräsung M-B auf, welche sich von Kontaktierungslage zur Maschine (Kupfer, vergoldet) 28 durch die Gitterstruktur 25 bis 27 bis zur Lage mit Tiefenfräsleiter (Kupfer) 24 erstreckt. Die zu prüfende Leiterplatte 1 liegt zur Prüfung mittels des erfindungsgemäßen Verfahrens und Testvorrichtung schlussendlich auf der Isolationslage zwischen den Lagen 21 und 22 auf.

## Patentansprüche

1. Testverfahren für eine unbestückte Leiterplatte umfassen die Schritte:
a) Aussetzen der unbestückten Leiterplatte (1) unter Temperaturen eines Reflow-Lötverfahrens, und
b) Testen der elektrischen Verbindungen der unbestückten Leiterplatte (1).

2. Testverfahren nach Anspruch 1, **dadurch gekennzeichnet, dass** Schritt a) bei einer Temperatur im Bereich von 150°C bis 250°C durchgeführt wird, insbesondere ca. 210°C

3. Testverfahren nach Anspruch 1 oder 2, **dadurch gekennzeichnet, dass** Schritt b) bei einer Temperatur im Bereich von 100°C bis 120°C durchgeführt wird, insbesondere bei ca. 110°C.

4. Testverfahren nach einem der vorherigen Ansprüche, **dadurch gekennzeichnet, dass** Schritt a) mittels einer ersten Heizplatte (2) und einer zweiten Heizplatte (3) durchgeführt wird, wobei die unbestückte Leiterplatte (1) zwischen der ersten Heizplatte (2) und der zweiten Heizplatte (3) angeordnet ist, wobei insbesondere die erste Heizplatte (2), die unbestückte Leiterplatte (1) und die zweite Heizplatte (3) durch eine erste Rahmenplatte (4) und eine zweite Rahmenplatte (5) umfasst werden.

5. Testverfahren nach Anspruch 4, **dadurch gekennzeichnet, dass** die erste Heizplatte (2) und/oder die zweite Heizplatte (3) einen Heizleiter (6) umfassen, vorzugsweise einen Heizleiter (6) mit mäandrischer Form.

6. Testverfahren nach der Anspruch 4 oder 5, **dadurch gekennzeichnet, dass** die erste Heizplatte (2), die zweite Heizplatte (3), die erste Rahmenplatte (4) und/oder die zweite Rahmenplatte (5) eine Vielzahl von Öffnungen (8) aufweist.

7. Testverfahren nach einem der vorherigen Ansprüche, **dadurch gekennzeichnet, dass** das Testen der elektrischen Verbindungen einen Durchgangstest und ein Isolationstest umfasst.

8. Testvorrichtung für einen Funktionstest einer unbestückten Leiterplatte umfassend:
- eine erste Heizplatte (2) und eine zweite Heizplatte (3), wobei die erste Heizplatte (2) und die zweite Heizplatte (3) zur Aufnahme einer unbestückten Leiterplatte (1) ausgebildet sind, und
- eine erste Rahmenplatte (4) und eine zweite Rahmenplatte (5), wobei die erste Rahmenplatte (4) und die zweite Rahmenplatte (5) zur Aufnahme der ersten Heizplatte (2) und der zweiten Heizplatte (3) ausgebildet sind.

9. Testvorrichtung für einen Funktionstest einer unbestückten Leiterplatte gemäß Anspruch 8, **dadurch gekennzeichnet, dass** die erste Heizplatte (2) und/oder die zweite Heizplatte (3) einen Heizleiter (6) umfassen, vorzugsweise einen Heizleiter (6) mit mäandrischer Form.

10. Testvorrichtung für einen Funktionstest einer unbestückten Leiterplatte gemäß Anspruch 8 oder 9, **dadurch gekennzeichnet, dass** die erste Heizplatte (2) und/oder die zweite Heizplatte (3) eine Beschichtung aus Kupfer (7) aufweisen.

11. Testvorrichtung für einen Funktionstest einer unbestückten Leiterplatte gemäß einem der Ansprüche 8 bis 10, **dadurch gekennzeichnet, dass** die erste Rahmenplatte (4) und/ die zweite Rahmenplatte (5) aus einem kupferfreien Leiterplattenmaterial gefertigt ist.

12. Testvorrichtung für einen Funktionstest einer unbestückten Leiterplatte gemäß einem der Ansprüche 8 bis 11, **dadurch gekennzeichnet, dass** die erste Heizplatte (2) und/oder die zweite Heizplatte (3) und/oder die erste Rahmenplatte (4) und/oder die zweite Rahmenplatte (5) eine Vielzahl von Öffnungen (8) aufweist.

13. Testvorrichtung für einen Funktionstest einer unbestückten Leiterplatte gemäß einem der Ansprüche 8 bis 12, weiterhin umfassend ein magnetisches Element, welches dazu ausgebildet ist, die erste Heizplatte (2) und die zweite Heizplatte (3) oder die erste Rahmenplatte (4) und die zweiten Rahmenplatte (5) zusammen zu halten.

14. Testvorrichtung für einen Funktionstest einer unbestückten Leiterplatte gemäß einem der Ansprüche 8 bis 13, **dadurch gekennzeichnet, dass** die erste Heizplatte (2) und die erste Rahmenplatte (4) und/oder die zweite Heizplatte (3) und die zweite Rahmenplatte (5) miteinander laminiert sind.

15. Herstellungsverfahren für eine bestückte Leiterplatte, umfassend die Schritte:
- Bereitstellen einer Vielzahl von unbestückten Leiterplatten (1),
- Testen der Vielzahl von unbestückten Leiterplatten mit einem Testverfahren gemäß einem der Ansprüche 1 bis 7,
- Auswählen einer unbestückten Leiterplatte mit intakten elektrischen Verbindungen aus der Vielzahl der getesteten unbestückten Leiterplatten,
- Bestücken der ausgewählten unbestückten Leiterplatte mit intakten elektrischen Verbindungen mit einer oder mehrerer elektronischer Komponenten, und
- Durchführen eines Reflow-Schrittes mit der bestückten Leiterplatte.
